Europäisches Patentamt

European Patent Office

Office européen des brevets

(11) Veröffentlichungsnummer: **0 151 730**

**A1**

(12) **EUROPÄISCHE PATENTANMELDUNG**

(21) Anmeldenummer: 84114949.5

(22) Anmeldetag: 07.12.84

(51) Int. Cl.⁴: **G 01 S 13/82**
**G 08 C 17/00**

(30) Priorität: 24.12.83 DE 3347044

(43) Veröffentlichungstag der Anmeldung:
21.08.85 Patentblatt 85/34

(84) Benannte Vertragsstaaten:
CH FR GB IT LI SE

(71) Anmelder: BROWN, BOVERI & CIE Aktiengesellschaft
Kallstadter Strasse 1
D-6800 Mannheim 31(DE)

(72) Erfinder: Strietzel, Rainer
Im Schnepfengrund 8
D-6900 Heidelberg 1(DE)

(72) Erfinder: Siedelhofer, Bernd, Dipl.-Ing.
Siegfriedstrasse 30
D-6905 Schriesheim(DE)

(74) Vertreter: Kempe, Wolfgang, Dr. et al,
c/o Brown, Boveri & Cie AG Postfach 351
D-6800 Mannheim 1(DE)

(54) Empfangseinrichtung für Funkempfänger.

(57) Durch zwei in einem festen Abstand angeordnete Mischdioden (2, 3), wobei dieser so gewählt ist, daß sich die
Phasenlage der ein- und auslaufenden Wellen an den beiden
Mischdioden um λ/4 unterscheidet, können über die Antenne
(1) empfangene Signale derart verarbeitet werden, daß nach
zweikanaliger Mischung, Demodulation, Verstärkung,
Gleichrichtung und mittels eines nachgeschalteten Summationsverstärkers (10) und eines Begrenzerverstärkers (11) ein
gleichbleibendes, schwundfreies Empfangssignal erzielbar
ist.

AUSGANGSSIGNAL

BROWN , BOVERI & CIE AKTIENGESELLSCHAFT

Mannheim                                    20. Dez. 1983

Mp.-Nr.   684/83                            ZPT/P3-NL/Bt

— 1 —

Empfangseinrichtung für Funkempfänger

Die Erfindung bezieht sich auf eine Empfangseinrichtung
für Funkempfänger, bestehend aus einer Antenne und einem
HF-Generator sowie einer Signalverarbeitungsanordnung.
Die Empfangseinrichtung findet beispielsweise Anwendung
bei einem Datenaustausch zwischen zwei Funkgeräten.

Aus der DE-PS 25 08 201 ist eine Anordnung bekannt, bei
der mittels Mikrowellen zwischen zwei Einrichtungen Informationen ausgetauscht werden. Eine Sende- und Empfangseinrichtung wird dabei von einer anderen Sende- und Empfangseinrichtung hochfrequenzmäßig mit Energie versorgt.
Während man für die Energieversorgung eine hohe Sendeleistung benötigt, genügt für das Informationssignal (zweite
Frequenz) eine geringere. Der Träger der hochfrequenten
unmodulierten Energiestrahlung wird an der Antenne reflektiert und als amplitudenmodulierte Schwingung auf die
Sendeeinrichtung zurückgeworfen. Die AM-Modulation entsteht dabei durch den elektrisch einstellbaren Reflexionsgrad (Verstimmung) der Antenne. Betreibt man eine Antenne
bei ihrer Resonanzfrequenz,dann wirkt sie als Saugkreis
und die Reflexion einfallender elektromagnetischer Strahlung wird minimal. Durch eine elektrische Verstimmung der

...

Antenne läßt sich eine starke Zunahme der Reflexion erreichen. Die Antennenspannung schwankt also in ihrer Höhe (AM-Modulation) entsprechend der Verstimmung der Antenne.

Bei ungünstigem Abstand zwischen beiden Sende- und Empfangseinrichtungen ist es möglich, daß die reflektierte Welle gegenüber der ankommenden Welle um 180° phasenverschoben ist, d. h. das Empfangssignal löscht sich aus. Dieser in der Kurzwellentechnik als "fading" bekannte Effekt kann für eine gewisse Zeit eine vollständige Informationsübertragung unterbinden. Zur Lösung dieses Problems kann man im Abstand von $\lambda/4$ zwei Empfangseinrichtungen einsetzen, die umschaltbar sind und dadurch immer ein Spannungsmaximum erbringen. (Aufsatz in "Proceedings of the IEEE" vom Aug. 1975 mit dem Titel "Short Range Radio-Telemetrie For Electronic Identification, Using Modulated RF Backscatter"). Derartige Anordnungen sind durch die Verwendung von zwei Antennen, Kopplern, Phasenschieber, zwei Mischern usw. aufwendig.

Es ist deshalb Aufgabe der Erfindung, an einer Hochfrequenz-Empfangsstelle auftretende Nullstellen auf einfache Art zu beseitigen.

Erfindungsgemäß wird dies durch die Merkmale des Anspruchs erzielt.

Vorteilhaft bei der erfindungsgemäßen Empfangseinrichtung ist, daß ohne großen Bauelementeaufwand unabhängig vom Abstand zur Sendeeinrichtung immer ein gleichmäßiges Signal zur Verfügung steht. Dabei ist innerhalb der Empfangseinrichtung nur noch eine Antenne vorgesehen, die an eine Leitung angeschlossen ist, die 2 getrennte Empfangsdioden enthält. Dieses Empfangsgebilde läßt

...

- 3 -

0151730

sich auch in Planartechnik herstellen, wodurch eine weitere Platzeinsparung erzielbar ist. Weitere Vorteile sind aus dem nachfolgenden Ausführungsbeispiel ersichtlich.

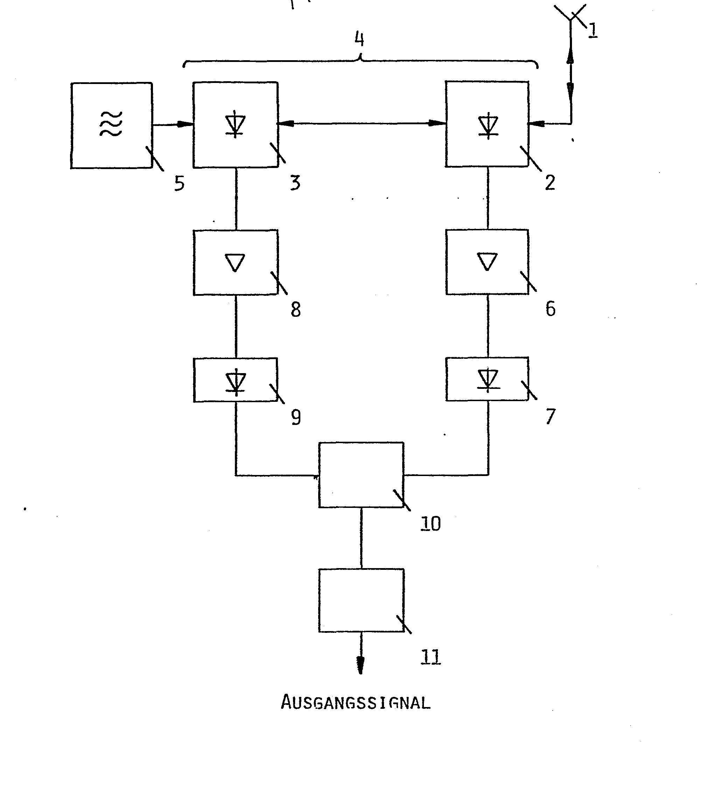

Ein Ausführungsbeispiel der erfindungsgemäßen Einrichtung wird nachstehend anhand der Zeichnung näher erläutert.

Über eine Hochfrequenzstrecke, vorwiegend im Frequenzbereich von mehreren Giga-Hertz werden Informationen auf die erfindungsgemäße Einrichtung übertragen. Eine Antenne 1 empfängt diese AM-modulierten Signale und leitet sie auf die beiden Mischdioden 2 und 3 weiter. Die Antenne 1 ist an eine Leitung 4 angeschlossen, in welcher die beiden Mischdioden 2 und 3 so angeordnet sind, daß sich die Phasenlage der ein- und auslaufenden Wellen an den beiden Mischdioden um $\lambda$/4 unterscheidet. Ein HF-Generator 5 erzeugt eine unmodulierte Spannung im Bereich von 5,8 GHz. Die HF-Spannung wird mit dem amplitudenmodulierten Signal von der Empfangsantenne 1 in den Dioden 2 und 3 gemischt. Am Ausgang der Mischdiode 3 entsteht dann ein (demoduliertes) NF-Signal, das weiterverarbeitet wird. Dieselbe Mischung des erzeugten HF-Signals mit dem empfangenen AM-Signal erfolgt in der Mischdiode 2. Da beide Mischdioden 2 und 3 räumlich so angeordnet sind, daß sich die Phasenlage der ein- und auslaufenden Wellen an den beiden Mischdioden um $\lambda$/4 unterscheidet, kann das empfangene Antennensignal immer nur mit einer unterschiedlichen Phasenlage (im vorliegenden Fall 90°) auf die Mischdioden 2 und 3 treffen.

Durch die Mischung an den beiden Dioden 2 und 3 mit den Spannungen aus dem HF-Generator werden zwei niederfrequente Signale erzeugt (Demodulation). Die von der Antenne 1 mit unterschiedlicher Phasenlage empfangenen Signale ergeben nach der Mischung unterschiedlich große

...

0151730

Signalamplituden. Der Mischdiode 2 ist ein Verstärker plus Filter 6 und ein Gleichrichter 7 nachgeordnet. Ebenso ist der Mischdiode 3 ein Verstärker plus Filter 8 und ein Gleichrichter 9 nachgeschaltet. Die beiden unterschiedlichen Signale aus den Mischdioden 2 und 3 vereinen sich wieder in dem Summationsverstärker 10, dem ein Begrenzerverstärker 11 nachgeschaltet ist.

Diese zweikanalige Verarbeitung der von der Antenne 1 empfangenen Signale erfolgt derart, daß nach der Mischung bzw. Demodulation die in ihrer Amplitude unterschiedlichen Nutzsignale verstärkt und von HF-Resten befreit werden (in den Bauelementen 6 bzw. 8). Die nachgeschalteten Gleichrichterstufen 7 bzw. 9 liefern dem Summationsverstärker 10 Signale gleichen Vorzeichens. Nach dem Summationsverstärker 10 ergibt sich dann ein konstanter Spannungswert, der nach Verstärkung als Ausgangssignal zur Verfügung steht bzw. digital oder analog weiterverarbeitet werden kann.

- 5 -

0151730

<u>A n s p r u c h</u>

Empfangseinrichtung für Funkempfänger, bestehend aus einer Antenne und einem HF-Generator sowie einer Signalverarbeitungsanordnung, <u>dadurch gekennzeichnet,</u> daß zwischen der Antenne (1) und dem HF-Generator (5) zwei in festem Abstand zueinander angeordnete Mischdioden (2 bzw. 3) geschaltet sind, wobei der feste Abstand durch ein Leitungsstück (4) dargestellt ist, der so gewählt ist, daß sich die Phasenlage der ein- und auslaufenden Wellen an den beiden Mischdioden um $\lambda$/4 unterscheidet, daß getrennte Kanäle, bestehend aus Verstärker (6) und Gleichrichter (7) bzw. Verstärker (8) und Gleichrichter (9) jeder Mischdiode (2, 3) nachgeschaltet sind, und daß die in ihrer Amplitude unterschiedlichen Signale aus den beiden Kanälen im Summationsverstärker (10) zusammengefügt und verstärkt als Ausgangssignal zur Verfügung stehen.

AUSGANGSSIGNAL

**Europäisches Patentamt**

## EUROPÄISCHER RECHERCHENBERICHT

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-4 075 632 (H.A. BALDWIN et al.) <br> * Figuren 2,8; Spalte 4, Zeilen 54-63; Spalte 8, Zeilen 28-35; Spalte 9, Zeilen 2-51 * | 1 | G 01 S 13/82 <br> G 08 C 17/00 |
| Y | US-A-3 728 721 (A.Y. LEE et al.) <br> * Figur 1; Spalte 5, Zeilen 11-21 * | 1 | |
| A | US-A-4 360 810 (J.A. LANDT) <br> * Figur 1, Zusammenfassung * | | |
| A | EP-A-0 082 491 (BROWN, BOVERI & CIE.) <br> * Figur 1; Seite 2, Zeile 29 - Seite 3, Zeile 5 * | | RECHERCHIERTE SACHGEBIETE (Int. Cl.4) |
| A | US-A-4 200 870 (C. GABBITAS) <br> * Figur 1; Spalte 3, Zeilen 54-68 * | | G 01 S 13/80 <br> G 01 S 13/82 <br> G 08 C 17/00 |

Der vorliegende Recherchenbericht wurde für alle Patentansprüche erstellt.

| Recherchenort | Abschlußdatum der Recherche | Prüfer |
|---|---|---|
| BERLIN | 20-03-1985 | BREUSING J |